# FASCICULE DE BREVET EUROPEEN

(11) **EP 3 468 874 B1**
(45) Date de publication et mention de la délivrance du brevet: **29.04.2020**
(21) Numéro de dépôt: 17736986.5
(22) Date de dépôt: 12.06.2017
(51) Int. Cl.: B64D 37/34, F02C 7/224, H01L 23/367

(54) **INTÉGRATION D'UN MATÉRIAU À CHANGEMENT DE PHASE POUR LIMITER LA TEMPÉRATURE DU CARBURANT À PARTIR D'UN MODULE ÉLECTRONIQUE**
INTEGRATION EINES SPEICHERSTOFFES ZUR BEGRENZUNG DER TEMPERATUR EINES BRENNSTOFFES VON EINEM ELEKTRONISCHEN MODUL
INTEGRATION OF A PHASE-CHANGE MATERIAL FOR LIMITING THE TEMPERATURE OF FUEL FROM AN ELECTRONIC MODULE

(30) Priorité: 13.06.2016 FR 1655451
(43) Date de publication de la demande: 17.04.2019
(73) Titulaire: Safran Helicopter Engines, 64510 Bordes (FR)
(72) Inventeur: KLONOWSKI, Thomas, 77550 Moissy-Cramayel (FR); SERGHINE, Camel, 77550 Moissy-Cramayel (FR)
(74) Mandataire: Regimbeau
(86) Numéro de dépôt international: PCT/FR2017/051506
(87) Numéro de publication internationale: WO 2017/216462

(56) Documents cités:
- WO-A1-2014/105331
- US-A1- 2012 240 593
- US-A1- 2013 147 050

## Description

### DOMAINE TECHNIQUE GENERAL

L'invention concerne l'alimentation d'un groupe moteur en carburant, et en particulier, la gestion de l'état de phase du carburant.

Plus spécifiquement, l'invention concerne les groupes moteurs comprenant un moteur thermique et une machine électrique.

On entend par « moteur thermique à turbine », dans le présent contexte, toute machine permettant la conversion de l'énergie thermique d'un fluide de travail en énergie mécanique par détente dudit fluide de travail dans une turbine.

Plus particulièrement, ce fluide de travail peut être un gaz de combustion résultant de la réaction chimique d'un carburant avec de l'air dans une chambre de combustion, après la compression de cet air dans un compresseur actionné par la turbine à travers un premier arbre rotatif.

Ainsi, les moteurs thermiques à turbine, telles que compris dans le présent contexte, comprennent les turboréacteurs à flux simple ou double, les turbopropulseurs, les turbomoteurs ou les turbines à gaz, entre autres.

Dans la description qui suit, les termes "amont" et "aval" sont définis par rapport au sens de circulation normal du fluide de travail dans la turbomachine.

Le carburant alimentant des moteurs thermiques à turbine peut comprendre des impuretés, et notamment de l'eau en suspension. A des températures normales la présence de traces d'eau dans le carburant n'est pas très problématique. Toutefois, quand les températures sont basses, cette eau peut geler. Les particules de glace résultantes peuvent éventuellement bloquer le passage du carburant, notamment en s'agglomérant à l'entrée des filtres typiquement utilisés pour empêcher le passage d'autres impuretés solides. En conséquence, il convient d'éviter ce givrage dans le circuit de carburant.

### ETAT DE L'ART

Une première solution contre le gel du carburant consiste à ajouter des additifs, coûteux, toxiques et contraignants. Cette solution est volontairement écartée.

Une deuxième solution consiste, comme présenté dans le document US 20120240593, à récupérer la chaleur dégagée par un circuit électronique, en l'occurrence un circuit électronique de conversion de puissance (GCU pour « *Generator Control Unit* »), pour réchauffer le carburant et empêcher que ce dernier ne gèle. Un échangeur de chaleur permet d'effectuer les transferts thermiques.

Le GCU fonctionne alors comme un radiateur.

Dans le document précité, la gestion du transfert de chaleur entre le GCU et le carburant se fait par contrôle du débit de fluide, ou par ajout d'un radiateur électrique dédié supplémentaire, qui permet d'une part de générer de la chaleur supplémentaire et en de solliciter davantage le GCU, qui à son tour chauffe davantage.

Néanmoins, il existe un risque, non mentionné dans le document précité, que le carburant reçoive trop d'énergie et puisse atteindre sa température de vaporisation. En effet, certaines électroniques embarquées fonctionnent pendant des durées très courtes, ce qui implique une puissance élevée. En outre, le voltage utilisé, souvent de l'ordre de quelques dizaines de volts, provoque des ampérages très élevées, d'où une génération de chaleur importante.

Ce phénomène de vaporisation doit être impérativement être évité.

### PRESENTATION DE L'INVENTION

L'invention vise à remédier aux inconvénients précités en proposant un ensemble comprenant :
Un circuit d'alimentation en carburant configuré pour alimenter un moteur thermique à turbine en carburant,
Un module électronique,
Une source d'énergie pour fournir le module électronique en électricité,
Un échangeur de chaleur positionné pour permettre un flux de chaleur du module électronique vers le circuit d'alimentation en carburant,
   l'ensemble étant caractérisé en ce que le module électronique comprend un matériau à changement de phase (PCM), configuré pour changer d'état lorsque sa température atteint une température prédéterminée de changement de phase.

Grâce au matériau PCM, l'élévation de température est mieux diffusée dans le temps, ce qui permet de limiter les pics de température et ainsi d'éviter d'atteinte la température de vaporisation de l'essence.
De plus, le matériau PCM protège le module électronique de ces pics de température qui peuvent l'endommager.
Le matériau PCM permet ainsi de répartir le flux de chaleur d'une façon optimisée entre le module électronique et le carburant.

Afin d'empêcher le carburant de se vaporiser, la température de changement de phase du matériau PCM est choisie de sorte à être inférieure à la température de vaporisation dudit carburant qui circule dans le circuit d'alimentation en carburant.

L'invention peut comprendre les caractéristiques suivantes, prises seules ou en combinaison :
- ladite température prédéterminée de changement de phase est inférieure à la température de vaporisation du carburant,
- le module électronique est un module électronique de puissance, configuré pour convertir l'énergie fournie par la source d'énergie,
- la température de changement de phase est inférieure à 150°C, préférablement inférieure à 140°C.
- le module électronique comprend les éléments suivants :
   un substrat de base formant un support,
   des composants électroniques, positionnés sur le support,
   et dans lequel l'échangeur est situé, par rapport au substrat de base, du côté opposé aux composants,
- les composants électroniques sont encapsulés dans du matériau à changement de phase PCM,
- du matériau à changement de phase PCM est intégré au substrat de base,
- le module électronique comprend une plaque froide, et dans lequel du matériau à changement de phase est intégré à la plaque froide.
- la plaque froide est positionnée entre le substrat de base et l'échangeur de chaleur,
- l'échangeur de chaleur est intégré à la plaque froide,

L'invention propose aussi un groupe moteur comprenant :
Un moteur thermique à turbine,
Un ensemble tel que décrit précédemment,
   dans lequel le circuit d'alimentation en carburant est configuré pour alimenter le moteur thermique.

La source d'énergie est avantageusement une machine électrique pouvant fonctionner en moteur ou en générateur et dans lequel la machine électrique est couplée mécaniquement à un arbre tournant du moteur thermique.

L'invention propose aussi un procédé de réchauffement de carburant à l'aide d'un ensemble ou d'un groupe moteur tel que décrit précédemment, dans lequel le carburant est chauffé, dans l'échangeur de chaleur du circuit d'alimentation en carburant par la chaleur émise par le module électronique au travers du matériau à changement de phase PCM.

L'invention propose aussi l'utilisation de matériau à changement de phase PCM pour contrôler le transfert thermique entre d'une part un module électronique dégageant de la chaleur lorsqu'il est alimenté en énergie, et d'autre part un carburant pour turbine à gaz, par le biais d'un échangeur de chaleur.

### PRESENTATION DES FIGURES

D'autres caractéristiques, buts et avantages de l'invention ressortiront de la description qui suit, qui est purement illustrative et non limitative, et qui doit être lue en regard des dessins annexés, sur lesquels :
- la figure 1 illustre schématiquement un module d'électronique de puissance et un échangeur de chaleur de groupe moteur, représentée sans matériau PCM à des fins de clarté,
- la figure 2 est similaire à la figure 1, mais avec trois variantes d'intégration de matériau PCM, et avec un ajout d'une plaque froide,
- la figure 3 représente des courbes de température relatives à l'utilisation de matériau PCM,
- la figure 4 illustre schématiquement un aéronef avec un groupe moteur comportant deux turbomoteurs et deux moteurs-générateurs électriques,
- la figure 5 illustre plus spécifiquement ce groupe moteur.

### DESCRIPTION DETAILLEE

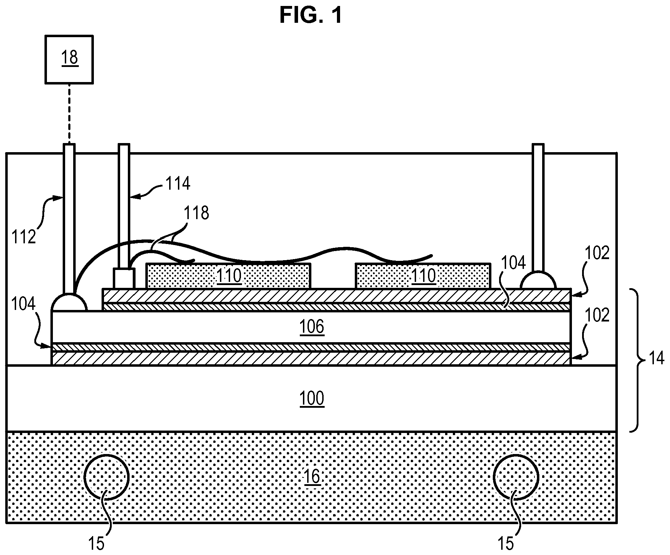

En référence à la **figure 1****,** on définit un ensemble comprenant un circuit d'alimentation en carburant 15, un module électronique 14 et une source d'énergie 13 qui apporte de l'énergie, typiquement de l'électricité au module 14.
Le circuit d'alimentation en carburant15 a pour fonction d'alimenter un moteur thermique à turbine en carburant. Des modes de réalisations particuliers seront détaillés par la suite.
Le module électronique 14 comprend généralement au moins un circuit électronique sur lequel sont reliés entre eux des composants électroniques aptes à traiter des signaux électriques (information ou énergie).
Par conséquent, lorsqu'il est sollicité par la source d'énergie 13, le module 14 dégage de la chaleur. Afin que cette chaleur soit transmise vers le circuit d'alimentation en carburant 15, un échangeur de chaleur 16 est prévu. Typiquement, l'échangeur de chaleur 16 est positionné entre le module électronique 14 et le circuit d'alimentation en carburant 15a, 15b.

L'échangeur de chaleur 16 permet d'optimiser le flux thermique entre le module 14 et le circuit d'alimentation 15. Il peut prendre différentes formes, comme un échangeur à plaques, à ailettes, ou simplement sous forme de ramifications de tuyaux favorisant l'échange thermique.

Le module électronique 14 comprend dans un mode de réalisation un substrat de base 100 formant support sur lequel sont fixé des composants électroniques 110, comme des transistors bipolaire à grille isolée, des diodes, des condensateurs, des inductances, etc. Comme représenté en **figure 1****,** ces composants 110 peuvent nécessiter des émetteurs 112, des portes 114, un collecteur 116 et des fils de liaisons 118 par exemple.
Différentes couches de matériaux, comme un joint brasé 102, une semelle en cuivre 104, un autre substrat d'isolation 106, par exemple en céramique, pour réaliser des interconnexions entre les semi-conducteurs et avec des circuits externes sur la semelle en cuivre 104, sont classiquement prévues pour le fonctionnement du module électronique.

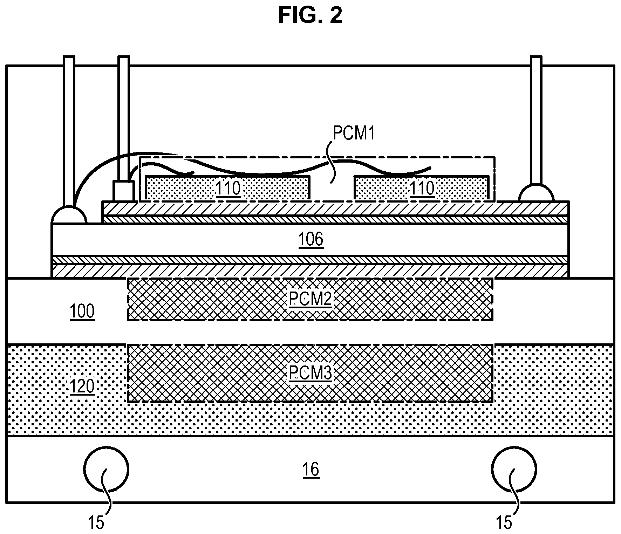

Afin de mieux réguler le transfert d'énergie, le module électronique 14 comprend un matériau à changement de phase, référencé PCM pour « *Phase-change material* ». La **figure 2** représente divers modes de réalisation détaillés par la suite.
Les matériaux PCM changent d'état, généralement de l'état solide vers l'état liquide, dès lors que leur température de fusion est atteinte. Comme il existe aussi des matériaux PCM qui changent de phase d'un état solide ou liquide vers un état gazeux, on parle plus généralement de température de changement de phase Tf.
Cette température Tf est une caractéristique du matériau PCM.

Dans certaines phases de vol d'un aéronef, la demande de puissance électrique d'un système électrique peut être très élevée sur des temps qui ne dépassent pas quelques dizaines de secondes voire la minute. Dans ces conditions où une dissipation thermique importante est requise mais qui soit cyclique ou transitoire, l'utilisation de matériaux PCM permet une meilleure gestion de la thermique au plus près des composants électroniques 110 critiques tels que les composants statiques, condensateurs, self, etc.
En effet atteignant sa température de fusion donc en passant de l'état solide à l'état liquide le matériau PCM va absorber une quantité de chaleur tout en restant à la même température (le temps que l'intégralité du matériau ait changé d'état) et un transfert thermique va alors s'opérer entre les composants électroniques 110 à l'intérieur du module électronique 14 et ce matériau PCM. Cette absorption est liée à l'enthalpie de changement d'état du matériau PCM, aussi appelé chaleur latente, qui correspond à l'énergie que doit recevoir une unité de masse du matériau pour changer d'état.

Le matériau PCM va alors absorber le pic de température.

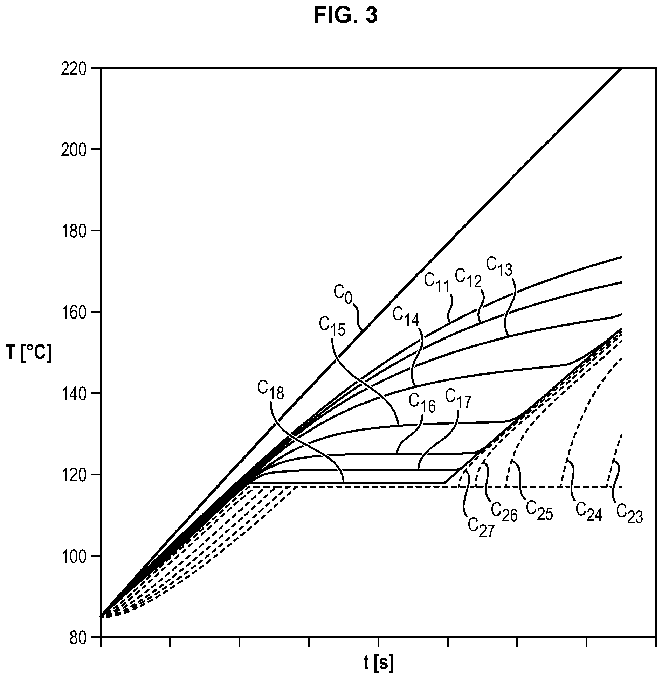

En effet, l'une des principales problématiques du développement des électroniques à bord des aéronefs est celle de la tenue en température des composants électroniques 110 notamment ceux qui sont brasés/ou soudés sur le substrat 100. En effet les contraintes thermomécaniques entre le composant 110 et le substrat 100 peuvent dans certains cas provoquer la délamination de la brasure ou de la soudure du composant sur son substrat, ce qui peut détruire le composant. De telles utilisations de matériau PCM sont déjà connues, comme dans le document US 20130147050.
Le matériau PCM permet aussi des gains en matière de dimensionnement et de volume occupé. En effet, les composants électroniques 110 tels que les transistors, condensateurs, selfs, peuvent être dimensionnés non pas sur un pic de température maximal mais sur une température inférieure moyennée.
Par conséquent, le matériau PCM a un premier rôle, qui est d'absorber de la chaleur pour empêcher le module électronique 14 de dépasser une température critique. La **figure 3** illustre cette absorption en fonction du temps : la courbe C0 représente l'élévation de température du module électronique 14 en l'absence de matériau PCM, les courbes C11 à C18 représentent l'élévation de température du module électronique 14 en présence de matériau PCM pour différentes résistances thermiques entre le matériau PCM et le substrat 100, les courbes C23 à C27 représentent l'élévation de température du matériau PCM (en lien avec les courbes C13 à C17). On remarque que la température de changement de phase Tf du matériau PCM est légèrement inférieure à 120°C.

Néanmoins, comme indiqué précédemment, le module électronique 14 a aussi pour fonction de réchauffer le carburant. Or, il s'avère que des pics de puissance peut générer une chaleur trop importante et que la gestion du transfert de chaleur est problématique.
Par conséquent, le matériau PCM, qui a absorbé le pic de chaleur, le restitue progressivement vers l'échangeur 16a, 16b. Ainsi, le matériau PCM permet de moyenner le transfert thermique entre le module électronique 14 et le carburant.
De la sorte, les risques de vaporisation dudit carburant sont largement diminués.

L'intégration d'un matériau PCM dans une telle architecture d'échange thermique entre le module électronique 14 et le circuit de carburant 15 permet de mettre une barrière thermique qui, en diffusant dans le temps la chaleur, protège le carburant de la vaporisation, tout en protégeant le module 14 de la surchauffe. En outre, contrairement aux usages classiques de matériaux PCM dont le but est simplement d'absorber de la chaleur durant un intervalle de temps relativement court, le matériau PCM est ici utilisé comme radiateur, à partir de l'énergie emmagasinée via le module électronique 14.

Afin que cette fonction soit remplie, on choisit un matériau PCM dont la température de changement de phase Tf est inférieure à la température de vaporisation Tv du carburant.

On connait les carburants suivants, avec leur température typiques de début de vaporisation Tv indiquée entre parenthèses : JetA (180°C), JP8 et JP8+100 (170°C), JetA1 (170°C), JP5 (200°C), F76 (200°C), TS1 (160°C) et RT (160°C).
Pour ces carburants, une température Tf inférieure à 150°C, préférablement 140°C, encore préférablement inférieure ou égal à 130°C convient. Complémentairement, la température Tf est supérieure à 120°C, pour éviter que le changement d'état soit complètement effectué alors que le module électronique 14 n'a pas encore atteint des températures pouvant compromettre son fonctionnement.

On connait aussi les carburants suivants, avec leur température de vaporisation Tv entre parenthèses : JetB et JP4 (80°C), AvGas et AutGas (60°C).
Pour ces carburants, une température Tf inférieure à 50°C convient.

L'intégration des matériaux PCM dans le module électronique peut être effectuée de différentes façons, ainsi que représentées sur la **figure 2** qui schématisent trois variantes, non nécessairement exclusives les unes des autres.

Dans une première variante, les composants électroniques 110 sont encapsulés dans le matériau PCM1. Pour cela, une matrice spécifique comprenant du matériau PCM est utilisée. Cette variante impose que les composants électroniques 110 soient étanches.

Dans une deuxième variante, le matériau PCM2 peut être intégré dans le substrat 100. On connait notamment le document US2013/0147050 qui divulgue une telle intégration dans le substrat 100. Un volume spécifique doit alors être aménagé dans le substrat 100.

Dans une troisième variante, une plaque froide 120 est prévue contre le substrat 110, du côté opposé aux composants électroniques 110. La plaque froide 120 est donc positionnée entre l'échangeur de chaleur 16 et le substrat de base 100. La plaque froide 120 a pour fonction de favoriser le refroidissement du module électronique 14. Le matériau PCM3 est alors intégré à cette plaque froide 120.

Ces trois variantes peuvent être combinées sans difficultés.

Différents types d'échangeurs ont été décrits précédemment. Selon les types d'échangeur, le positionnement relatif du circuit de carburant et du substrat de base et/ou de la plaque froide peut être adapté. En particulier, l'échangeur de chaleur peut être logé dans le substrat de base 100 ou dans la plaque froide 120. L'échangeur peut alors prendre la forme d'un circuit fluide, comme une ramification de tuyau, aménagé dans la plaque. La circulation du fluide est alors préférablement forcée par une pompe dédiée.
Le matériau PCM peut comprendre des sels hydratés, des paraffines, et/ou des alcools.

L'avantage des matériaux PCM réside aussi dans le gain de masse et de volume par rapport à d'autres technologies.

Dans un mode de réalisation particulier, le module électronique 14 est un module de puissance, configuré pour convertir l'énergie fournie par la source d'énergie. Il est donc particulièrement soumis à des élévations de températures, en particulier pendant des temps très courts durant lesquels il est sollicité.
Dans ce mode de réalisation, les composants électroniques 110 peuvent notamment être des semi-conducteurs de puissance.

A présent, une architecture plus globale dans le cadre d'un hélicoptère va être décrite. Néanmoins, l'invention s'implémente sur tout aéronef comprenant de l'électronique générant de la chaleur, quel que soit le nombre de moteur ou leur type.

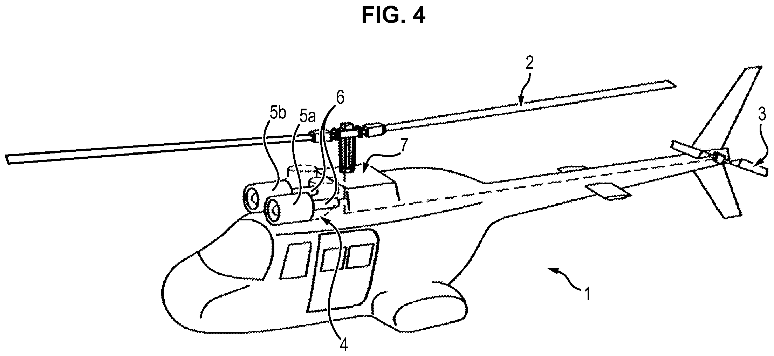

La **figure 4** illustre un aéronef 1 à voilure tournante, plus spécifiquement un hélicoptère avec un rotor principal 2 et un rotor de queue anti-couple 3 couplés à un groupe moteur 4 pour leur actionnement. Le groupe moteur 4 illustré comprend un premier moteur thermique 5a et une deuxième moteur thermique 5b. Ces moteurs thermiques 5a, 5b sont des moteurs thermiques à turbine et plus spécifiquement des turbomoteurs dont les arbres de prise de puissance 6 sont tous les deux reliés à une boîte de transmission principale 7 pour actionner le rotor principal 2 et le rotor de queue 3.

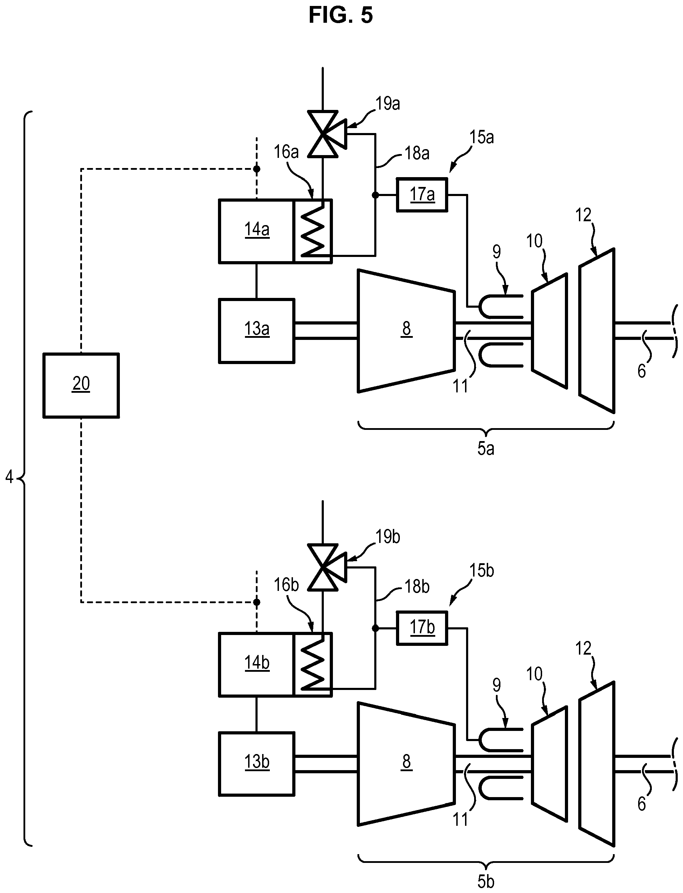

Le groupe moteur 4 est illustré en plus grand détail sur la **figure 5****.** Chaque moteur thermique 5a, 5b comprend un compresseur 8, une chambre de combustion 9, une première turbine 10 reliée par un arbre rotatif 11 au compresseur 8 et une deuxième turbine 12, ou turbine libre, couplée à l'arbre de prise de puissance 6. L'ensemble du compresseur 8, chambre de combustion 9, première turbine 10 et arbre rotatif 11 est aussi connu sous le nom de « générateur de gaz ». L'arbre rotatif 11 de chaque générateur de gaz est mécaniquement couplé à la source d'énergie 13a, 13b, qui est plus précisément une machine électrique 13a, 13b généralement sous la forme d'un moteur-générateur, connectée électriquement au module électrique 14a, 14b, qui est ici un module électronique de puissance, qui est plus spécifiquement un convertisseur de puissance connecté aussi électriquement à un dispositif de stockage électrique 20 et à un réseau électrique de l'aéronef 1. Ce dispositif de stockage électrique 20 peut par exemple être une batterie, quoique d'autres dispositifs de stockage électrique (p.ex. des piles à combustible ou des volants d'inertie) soient également envisageables.

Les machines électriques 13a, 13b servent tant au démarrage des moteurs thermiques 5a, 5b correspondants qu'à la génération d'électricité après ce démarrage. Dans le premier cas, la machine électrique 13a, 13b fonctionne en mode moteur, et le module d'électronique de puissance 14a, 14b assure son alimentation électrique à partir du réseau électrique de l'aéronef et/ou du dispositif de stockage électrique 20. Dans le deuxième cas, la machine électrique 13a, 13b fonctionne en mode générateur, et le module d'électronique de puissance 14a,14b adapte le courant généré à un voltage et ampérage appropriés pour l'alimentation du réseau électrique de l'aéronef et/ou du dispositif de stockage électrique 20.

En outre, toutefois, chaque machine électrique 13a, 13b peut également servir à maintenir le moteur thermique 5a, 5b correspondant en mode de veille, même pendant le vol de l'aéronef 1, en faisant tourner son arbre rotatif 11, avec la chambre de combustion 9 éteinte, à une vitesse réduite Nveille, qui peut être, par exemple, entre 5 et 20% d'un régime nominal N1 de l'arbre rotatif 11. En effet, il est connu que le maintien d'un moteur thermique à turbine en mode de veille sur un aéronef multi-moteur permet d'économiser du carburant en vol de croisière et d'accélérer son éventuel redémarrage.

La puissance fournie par le groupe moteur 4 peut varier sensiblement suivant l'étape de vol de l'aéronef 1. Ainsi, la puissance requise pour le régime de croisière est normalement sensiblement inférieure à la puissance maximale continue du groupe moteur 4, et encore moindre par rapport à sa puissance maximale de décollage. Or, le groupe moteur 4 étant dimensionné en fonction de cette dernière, il est sensiblement surdimensionné par rapport à la puissance requise pour le régime de croisière. En conséquence, en croisière, avec les deux moteurs thermiques 5a, 5b en fonctionnement, ils pourraient se retrouver éloignés de leur régime optimal de fonctionnement, ce qui se traduirait par une consommation spécifique relativement élevée. En principe, avec un groupe moteur comprenant une pluralité de moteurs thermiques, il est envisageable de maintenir le régime de croisière avec au moins un de ces moteurs thermiques éteint. Avec les autres moteurs thermiques fonctionnant à un régime alors plus proche de leur régime optimal, la consommation spécifique peut être réduite. Afin de permettre un tel mode de fonctionnement d'un groupe moteur, tout en assurant le démarrage immédiat du moteur thermique éteint, il a été proposé dans FR 2 967 132 de maintenir ce moteur thermique éteint en mode de veille.

Dans le groupe moteur 4 illustré sur la **figure 5****,** le premier moteur thermique 5a est donc éteint pendant le régime de croisière de l'aéronef 1, tandis que le deuxième moteur thermique 5b fournit toute la puissance au rotor principal 2 et au rotor de queue 3 à travers la boîte de transmission principale 7. La machine électrique 13b associé au deuxième moteur thermique 5b assure simultanément l'alimentation du réseau électrique de l'aéronef 1 à travers son module d'électronique de puissance 14b et l'alimentation de la machine électrique 13a à travers son électronique 14a. Afin de pouvoir assurer le démarrage d'urgence du premier moteur thermique 5a, notamment en cas de défaillance du deuxième moteur thermique 5b, le premier moteur thermique 5a est maintenu en mode de veille par actionnement de son arbre rotatif 11 par la machine électrique 13a correspondante, alimentée à travers son module d'électronique de puissance 14a.

Pour alimenter les moteurs thermiques 5a, 5b en carburant, chacun est associé aux circuits d'alimentation en carburant 15a, 15b, avec l'échangeur de chaleur 16a, 16b et, en outre, un filtre de carburant 17a,17b situé en aval de l'échangeur de chaleur 16a,16b suivant le sens de l'écoulement du carburant vers le moteur thermique 5a, 5b.

Comme illustré sur la **figure 3****,** chaque échangeur de chaleur 16a, 16b est adjacent à une base du module d'électronique de puissance 14a, 14b (par exemple une plaque froide 21) correspondant, dans un boitier 22, pouvant être étanche et commun au module d'électronique de puissance 14a, 14b et à l'échangeur de chaleur 16a, 16b correspondant, de manière à ce que le carburant circulant par l'échangeur de chaleur 16a ou 16b puisse être chauffé par de la chaleur générée par le fonctionnement du module d'électronique de puissance 14a, 14b, et simultanément contribuer au refroidissement du module d'électronique de puissance 14a,14b pour lui permettre de fonctionner dans une plage de température optimale. Typiquement, chaque module d'électronique de puissance 14a, 14b peut traiter une puissance Pe de l'ordre de 100 kW, avec des pertes thermiques de moins de 10 %, résultant ainsi en une puissance calorique Ph de, par exemple, moins de 10 kW, voire moins de 1 kW.

Toutefois, chaque module d'électronique de puissance 14a, 14b peut avoir un mode de fonctionnement normal et un mode de fonctionnement à rendement électrique dégradé pouvant être mis en œuvre pour générer un supplément de chaleur pour le réchauffement du carburant. Ce mode de fonctionnement à rendement dégradé peut être obtenu par exemple en imposant à des semi-conducteurs du module d'électronique de puissance 14a, 14b une fréquence de découpe plus élevée que celle qui serait normalement appliquée en fonction des critères de dimensionnement électriques usuels.
Chaque circuit d'alimentation en carburant 15a, 15b peut également comprendre un conduit de contournement 18a, 18b de l'échangeur de chaleur 16a,16b, ainsi qu'une vanne à trois voies 19a, 19b pour commander l'écoulement du carburant par l'échangeur de chaleur 16a, 16b ou par le conduit de contournement 18a, 18b.

Pour réchauffer le carburant alimentant un des moteurs thermiques 5a, 5b pendant un démarrage de celui-ci à basse température avant d'allumer la chambre de combustion 9, celui-ci est dirigé à travers l'échangeur de chaleur 16a,16b correspondant, dans lequel il est chauffé grâce à la chaleur générée par le fonctionnement du module d'électronique de puissance 14a,14b à travers lequel la machine électrique 13a,13b est alimentée électriquement pour faire tourner l'arbre rotatif 11 de ce moteur thermique 5a,5b. Si la chaleur générée par le module d'électronique de puissance 14a,14b en mode de fonctionnement normal est insuffisante pour permettre un démarrage rapide sans risque de colmatage du filtre de carburant 17a,17b par des particules de glace d'eau, un mode de fonctionnement à rendement électrique dégradé du module d'électronique de puissance 14a,14b peut être mise en œuvre pour augmenter la génération de chaleur dans ce module, et sa transmission, à travers l'échangeur de chaleur 16a,16b, vers le carburant.
Par contre, s'il n'est pas nécessaire de chauffer le carburant pour l'un ou l'autre des moteurs thermiques 5a,5b, ou de refroidir le module d'électronique de puissance 14a,14b associé, la vanne à trois voies 19a, 19b peut diriger le carburant à travers le conduit de contournement 18a, 18b correspondant.

## Revendications

1. Ensemble comprenant :
Un circuit d'alimentation en carburant (15, 15a, 15b) configuré pour alimenter un moteur thermique à turbine en carburant,
Un module électronique (14, 14a, 14b),
Une source d'énergie (13, 13a, 13b) pour fournir le module électronique (14, 14a, 14b) en électricité,
Un échangeur de chaleur (16, 16a, 16b) positionné pour permettre un flux de chaleur du module électronique (14, 14a, 14b) vers le circuit d'alimentation en carburant (15, 15a, 15b),
l'ensemble étant **caractérisé en ce que** le module électronique (14, 14a, 14b) comprend un matériau à changement de phase (PCM1, PCM2, PCM3), configuré pour changer d'état lorsque sa température atteint une température prédéterminée de changement de phase (Tf).

2. Ensemble selon la revendication précédente dans lequel ladite température prédéterminée de changement de phase (Tf) est inférieure à la température de vaporisation du carburant (Tv).

3. Ensemble selon l'une quelconque des revendications précédentes, dans lequel le module électronique (14, 14a, 14b) est un module électronique de puissance, configuré pour convertir l'énergie fournie par la source d'énergie (13, 13a, 13b).

4. Ensemble selon l'une quelconque des revendications précédentes, dans lequel la température de changement de phase (Tf) est inférieure à 150°C, préférablement inférieure à 140°C.

5. Ensemble selon l'une quelconque des revendications précédentes, dans lequel le module électronique (14, 14a, 14b) comprend les éléments suivants :
- un substrat de base (100) formant un support,
- des composants électroniques (110), positionnés sur le support,
et dans lequel l'échangeur (16, 16a, 16b) est situé, par rapport au substrat de base (100), du côté opposé aux composants (110).

6. Ensemble selon la revendication 5, dans lequel les composants électroniques (110) sont encapsulés dans du matériau à changement de phase (PCM1).

7. Ensemble selon la revendication 5 ou 6, dans lequel du matériau à changement de phase (PCM2) est intégré au substrat de base (100).

8. Ensemble selon la revendication 5 ou 6 ou 7, dans lequel le module électronique (14, 14a, 14b) comprend une plaque froide (120) et dans lequel du matériau à changement de phase (PCM3) est intégré à la plaque froide.

9. Groupe moteur (4) comprenant :
Un moteur thermique à turbine (5a, 5b),
Un ensemble selon l'une quelconque des revendications précédentes,
dans lequel le circuit d'alimentation en carburant (15, 15a, 15b) est configuré pour alimenter le moteur thermique (5a, 5b).

10. Groupe moteur (4) selon la revendication précédente, dans lequel la source d'énergie est une machine électrique (13, 13a, 13b) pouvant fonctionner en moteur ou en générateur et dans lequel la machine électrique est couplée mécaniquement à un arbre tournant du moteur thermique.

11. Procédé de réchauffement de carburant à l'aide d'un ensemble selon l'une quelconque des revendications 1 à 8 ou d'un groupe moteur selon l'une quelconque des revendications 9 à 10, dans lequel le carburant est chauffé, dans l'échangeur de chaleur (16, 16a, 16b) du circuit d'alimentation en carburant (15, 15a, 15b) par la chaleur émise par le module électronique (14) au travers du matériau à changement de phase (PCM1, PCM2, PCM3).

## Patentansprüche

1. Gruppe, umfassend:
einen Versorgungsschaltkreis für Kraftstoff (15, 15a, 15b), der zum Versorgen eines Verbrennungsmotors mit Turbine mit Kraftstoff ausgestaltet ist,
ein elektronisches Modul (14, 14a, 14b),
eine Energiequelle (13, 13a, 13b) zum Beliefern des elektronischen Moduls (14, 14a, 14b) mit elektrischer Energie,
einen Wärmetauscher (16, 16a, 16b), der angeordnet ist, um einen Wärmestrom des elektronischen Moduls (14, 14a, 14b) zum Versorungsschaltkreis für Kraftstoff (15, 15a, 15b) zu ermöglichen,
wobei die Gruppe **dadurch gekennzeichnet ist, dass** das elektronische Modul (14, 14a, 14b) ein Material mit Phasenänderung (PCM1, PCM2, PCM3) umfasst, das ausgestaltet ist, um den Zustand zu ändern, wenn seine Temperatur eine vorbestimmte Phasenänderungstemperatur (Tf) erreicht.

2. Gruppe gemäß dem voranstehenden Anspruch, bei der die genannte vorbestimmte Phasenänderungstemperatur (Tf) niedriger ist als die Verdampfungstemperatur des Kraftstoffs (Tv).

3. Gruppe gemäß irgendeinem der voranstehenden Ansprüche, bei der das elektronische Modul (14, 14a, 14b) ein elektronisches Leistungsmodul ist, das zum Umwandeln der von der Energiequelle (13, 13a, 13b) gelieferten Energie ausgestaltet ist.

4. Gruppe gemäß irgendeinem der voranstehenden Ansprüche, bei der die Phasenänderungstemperatur (Tf) niedriger ist als 150° C, bevorzugt nieder als 140° C.

5. Gruppe gemäß irgendeinem der voranstehenden Ansprüche, bei der das elektronische Modul (14, 14a, 14b) die folgenden Elemente umfasst:
- ein Basissubstrat (100), das einen Träger bildet,
- elektronische Bauteile (110), die auf dem Träger angeordnet sind,
und bei dem der Tauscher (16, 16a, 16b) in Bezug auf das Basissubstrat (100) auf der den Bauteilen (110) gegenüberliegenden Seite angeordnet ist,

6. Gruppe gemäß Anspruch 5, bei der die elektronischen Bauteile (110) in dem Material mit Phasenänderung (PCM1) verkapselt sind.

7. Gruppe gemäß Anspruch 5 oder 6, bei der das Material mit Phasenänderung (PCM2) in das Basissubstrat (100) eingebaut ist.

8. Gruppe gemäß Anspruch 5 oder 6 oder 7, bei der das elektronische Modul (14, 14a, 14b) eine kalte Platte (120) umfasst und bei der das Material mit Phasenänderung (PCM3) in die kalte Platte eingebaut ist.

9. Motorsatz (4), umfassend:
einen Verbrennungsmotor mit Turbine (5a, 5b),
eine Gruppe gemäß irgendeinem der voranstehenden Ansprüche,
bei der der Versorgungsschaltkreis mit Kraftstoff (15, 15a, 15b) zum Versorgen des Verbrennungsmotors (5a, 5b) ausgestaltet ist.

10. Motorsatz (4) gemäß dem voranstehenden Anspruch, bei dem die Energiequelle eine elektrische Maschine (13, 13a, 13b) ist, die als Motor und als Generator funktionieren kann und bei dem die elektrische Maschine mechanisch an eine sich drehende Welle des Verbrennungsmotors gekoppelt ist.

11. Erhitzungsverfahren von Kraftstoff mithilfe einer Gruppe gemäß irgendeinem der Ansprüche 1 bis 8 oder eines Motorsatzes gemäß irgendeinem der Ansprüche 9 bis 10, bei dem der Kraftstoff im Wärmetauscher (16, 16a, 16b) des Versorgungsschaltkreises mit Kraftstoff )15, 15a, 15b) durch die Wärme erhitzt wird, die vom elektronischen Modul (14) durch das Phasenänderungsmaterial (PCM1, PCM2, PCM3) abgegeben wird.

## Claims

1. An assembly comprising:
a fuel supply circuit (15, 15a, 15b) configured to supply a turbine heat engine with fuel,
an electronic module (14, 14a, 14b),
an energy source (13, 13a, 13b) for supplying the electronic module (14, 14a, 14b) with electricity,
a heat exchanger (16, 16a, 16b) positioned to allow heat flow from the electronic module (14, 14a, 14b) to the fuel supply circuit (15, 15a, 15b),
the assembly being **characterized in that** the electronic module (14, 14a, 14b) comprises a phase change material (PCM1, PCM2, PCM3) configured to change state when its temperature reaches a predetermined phase change temperature (Tf).

2. The assembly according to the preceding claim, wherein said predetermined phase change temperature (Tf) is less than the vaporisation temperature (Tv) of the fuel.

3. The assembly according to any of the preceding claims, wherein the electronic module (14, 14a, 14b) is an electronic power module, configured to convert the energy supplied by the energy source (13, 13a, 13b).

4. The assembly according to any of the preceding claims, wherein the phase change temperature (Tf) is less than 150°C, preferably less than 140°C.

5. The assembly according to any of the preceding claims, wherein the electronic module (14, 14a, 14b) comprises the following elements:
- a base substrate (100) forming a support,
- electronic components (110), positioned on the support,
and wherein the exchanger (16, 16a, 16b) is located, relative to the base substrate (100), to the side opposite the components (110).

6. The assembly according to claim 5, wherein the electronic components (110) are encapsulated in phase change material (PCM1).

7. The assembly according to claim 5 or 6, wherein phase change material (PCM2) is integrated into the base substrate (100).

8. The assembly according to claim 5 or 6 or 7, wherein the electronic module (14, 14a, 14b) comprises a cold plate (120) and wherein phase change material (PCM3) is integrated into the cold plate.

9. A power unit (4) comprising:
a turbine heat engine (5a, 5b),
an assembly according to any of the preceding claims,
wherein the fuel supply circuit (15, 15a, 15b) is configured to supply the heat engine (5a, 5b).

10. The power unit (4) according to the preceding claim, wherein the energy source is an electric machine (13, 13a, 13b) which can operate as an engine or generator and wherein the electric machine is mechanically coupled to a rotating shaft of the heat engine.

11. A method for heating fuel using an assembly according to any of claims 1 to 8 or a power unit according to any of claims 9 to 10, wherein the fuel is heated in the heat exchanger (16, 16a, 16b) of the fuel supply circuit (15, 15a, 15b) by the heat emitted by the electronic module (14) via the phase change material (PCM1, PCM2, PCM3).
